# FASCICULE DE BREVET EUROPEEN

(11) **EP 0 420 822 B1**
(45) Date de publication et mention de la délivrance du brevet: **07.02.1996**
(21) Numéro de dépôt: 90810743.6
(22) Date de dépôt: 27.09.1990
(51) Int. Cl.: G11C 27/02, G11C 16/06

(54) **Procédé de mémorisation de grandeurs analogiques et dispositif pour sa mise en oeuvre**
Verfahren zur Speicherung analoger Grössen und Einrichtung zur Durchführung des Verfahrens
Method of storing analogue values and device for its implementation

(30) Priorité: 29.09.1989 FR 8912739
(43) Date de publication de la demande: 03.04.1991
(73) Titulaire: CENTRE SUISSE D'ELECTRONIQUE ET DE MICROTECHNIQUE S.A., CH-2007 Neuchâtel (CH)
(72) Inventeur: Oguey, Henri, CH-2035 Corcelles (CH)
(74) Mandataire: Brulliard, Joel

(56) Documents cités:
- US-A- 4 057 788
- US-A- 4 181 980
- US-A- 4 627 027
- "A 1.5V Only CMOS EEPROM based on Fowler-Nordheim Emission - Design, Technology ans Applications", J.C. Martin and al., Swiss Electrotechnical Association Bulletin (Bulletin SEV/VSE), Vol. 75 (1984), No 3, pp 140 ss

## Description

La présente invention se rapporte aux dispositifs de mémoire non-volatile et concerne plus particulièrement un procédé et un dispositif permettant la mémorisation de grandeurs analogiques.

Des mémoires non-volatiles à inscription et effacement électriques, dites mémoires EEPROM pour "Electrically Erasable and Programable Read-Only Memory", présentent une structure de transistor MOS dont la grille est complètement isolée (c'est-à-dire flottante). L'état de tension de cette grille, qui détermine la conduction du transistor MOS, peut être modifié en injectant dans celle-ci ou en extrayant de celle-ci une certaine quantité de charges électriques. Une technique connue de modification de la charge de la grille flottante consiste à produire un courant, par effet tunnel à travers un isolant de très faible épaisseur, entre une zone dopée du substrat, dite zone d'injection, et la grille flottante. Cet effet tunnel, encore appelé émission de champ ou effet Fowler-Nordheim, se produit dès qu'une tension suffisante existe entre ladite zone d'injection et la grille flottante. Comme cette dernière est isolée, l'application de la tension requise se fait entre la zone d'injection et une électrode de commande qui est couplée capacitivement à ladite grille flottante. Une mémoire de ce type utilisant l'effet Fowler-Nordheim pour l'effacement a été décrite dans le brevet américain No 4 399 523.

La plupart des applications connues ne considèrent l'information stockée dans la mémoire que comme une information de type numérique, quand bien même une information de type analogique puisse être obtenue en convertissant plusieurs bits ainsi mémorisés. On a cependant déjà proposé, dans l'article de E. Säckinger et W. Guggenbühl paru dans la revue IEEE Journal of Solid-State Circuits, Vol. 23, No 6, Décembre 1988 et intitulé "An Analog Trimming Circuit Based on a Floating-Gate Device", d'utiliser la grandeur analogique stockée dans une cellule de mémoire EEPROM, en particulier pour réaliser des ajustements de circuits. Toutefois, les techniques de programmation utilisées, consistant à appliquer sur les électrodes de la mémoire des tensions continues élevées de signe approprié, ne permettent de fixer avec précision la charge existant sur la grille flottante qu'en recourant à un processus itératif de mesures et corrections successives, qui doit être mis en oeuvre pour chaque cellule individuelle. La grille flottante n'étant pas directement accessible, la mise en oeuvre de ce processus d'ajustement se révèle le plus souvent délicate et requiert, dans tous les cas, des éléments de circuit supplémentaires. De plus, le fait de devoir ajuster la charge stockée limite encore les applications de ces mémoires dans le domaine analogique.

Par ailleurs, le brevet américain US-A-4057788 décrit un procédé de mémorisation d'une grandeur analogique dans une cellule mémoire non-volatile de type MNOS consistant à appliquer sur l'électrode de commande de la cellule la somme d'une tension DC égale à la tension de seuil à mémoriser et d'une tension AC d'amplitude décroissante. Le brevet affirme qu'il est ainsi possible d'obtenir avec grande précision la tension de seuil désirée, mais ne fournit pas d'explications sur le mécanisme d'inscription impliquée.

Un des buts de la présente invention est précisément d'éviter les inconvénients mentionnés ci-dessus en permettant le stockage dans une mémoire d'une grandeur bien définie en une seule opération.

Ainsi un objet de l'invention est un procédé permettant de mémoriser dans une cellule de mémoire, présentant une structure de transistor MOS à grille flottante, une grandeur analogique en une seule opération de programmation.

Un autre objet de la présente invention est un procédé permettant d'utiliser les mêmes moyens pour mémoriser une grandeur analogique ou numérique ou pour effacer l'information mémorisée.

Un autre objet de l'invention est un dispositif pour la mise en oeuvre dudit procédé.

Le procédé de l'invention est défini par la revendication 1.

Selon une variante du procédé de l'invention, la tension alternative à appliquer à ladite électrode de commande ne comporte qu'une alternance positive et une alternance négative d'amplitude égale à ladite valeur donnée.

Un dispositif pour la mise en oeuvre du procédé de l'invention comporte d'une part, une cellule de mémoire réalisée sur un substrat de matériau semiconducteur et constituée par un transistor MOS à grille flottante, une électrode de commande couplée capacitivement à ladite grille flottante, une zone d'injection, séparée de la grille flottante par un isolant et capable d'injecter dans ou d'extraire de la grille flottante des charges électriques et d'autre part, un générateur de tension alternative capable de délivrer sur ladite électrode de commande au moins une alternance positive et une alternance négative d'amplitude égale à une valeur donnée et des moyens pour appliquer sur ladite zone d'injection une tension sensiblement égale à celle qui doit être mémorisée.

La tension mémorisée à l'aide du procédé et du dispositif de l'invention ne dépend que de la tension appliquée à la zone d'injection pendant la phase de programmation; elle est, en particulier, indépendante de la valeur de la tension alternative appliquée à l'électrode de commande (pour autant que celle-ci ait toutefois l'amplitude requise pour entraîner une modification de la charge de la grille flottante) ou de la durée de la programmation. De plus, grâce au procédé de l'invention, une seule électrode seulement de la cellule de mémoire est soumise à une tension élevée. Cela constitue un autre avantage par rapport à l'art antérieur.

D'autres objets, caractéristiques et avantages de la présente invention apparaîtront plus clairement à la lecture de la description suivante d'exemples de réalisation particuliers; ladite description étant faite à titre purement illustratif et en relation avec les dessins joints dans lesquels:
- la figure 1 montre une cellule de mémoire de type connu apte à être utilisée dans le cadre de la présente invention;
- la figure 2 montre d'une part, un schéma équivalent (fig. 2.a) de la cellule de la figure 1 et d'autre part la courbe de variation (fig. 2.b) du courant d'injection en fonction de la tension appliquée;
- la figure 3 montre l'évolution de la tension de la grille flottante lorsqu'une tension alternative (fig. 3.a) ou alternative et décroissante (fig. 3.b) est appliquée sur l'électrode de commande;
- la figure 4 montre une source de tension ajustable utilisant une cellule de mémoire selon les principes de l'invention;
- la figure 5 montre une source de courant ajustable;
- la figure 6 montre un circuit de mémoire de type numérique;
- la figure 7 montre un schéma de générateur de tension sinusoïdale amortie;
- la figure 8 montre une cellule de mémoire selon l'invention comportant une électrode supplémentaire de correction;
- la figure 9 montre un circuit utilisable pour la correction de la valeur mémorisée; et
- la figure 10 montre une autre variante de la cellule de mémoire de la figure 1.

Bien qu'également applicable à des éléments de mémoire réalisés à l'aide d'une technologie MOS à caissons de type p, la présente invention sera décrite ici en relation avec des exemples réalisés à l'aide d'une technologie CMOS à caissons de type n. Une cellule réalisée à l'aide d'une technologie CMOS à caissons de type p a été, par exemple, décrite dans l'article de J.C. Martin et B. Gerber intitulé "A 1.5V Only CMOS EEPROM based on Fowler-Nordheim Emission - Design, Technology and Applications" et paru dans Swiss Electrotechnical Association Bulletin (Bulletin SEV/VSE), Vol. 75 (1984), No 3, pp 140 ss.

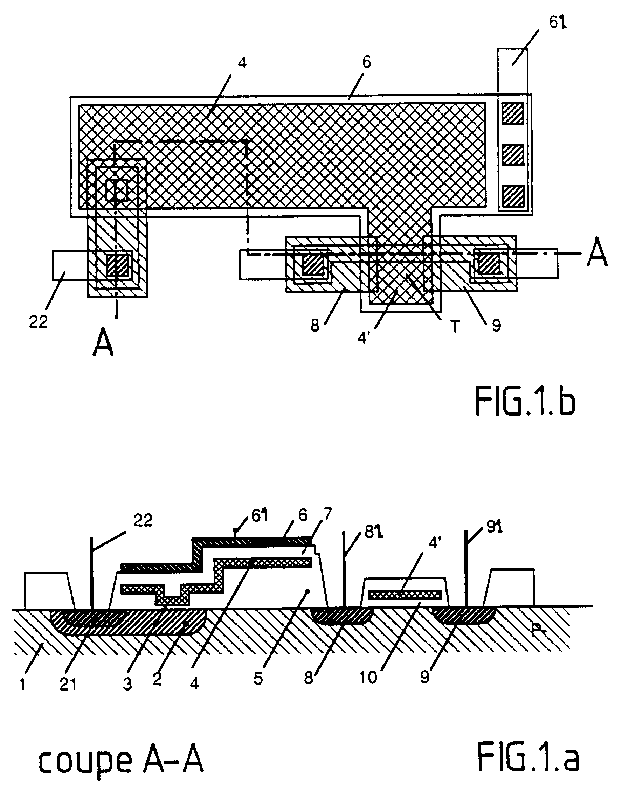

La figure 1 montre, en coupe (fig. 1.a) et à l'aide d'un plan de masques (fig. 1.b), une cellule de mémoire d'un type connu. Dans un substrat semiconducteur 1 de type p sont réalisées trois diffusions 2, 8 et 9 de type n constituant, respectivement, la zone d'injection d'une part, la source et le drain du transistor de lecture T d'autre part. La grille flottante en silicium polycristallin 4 est séparée du substrat par un oxyde épais 5, de la zone de canal du transistor T par un oxyde de grille 10 et de la zone d'injection par un oxyde mince d'injection 3. L'électrode de commande 6, réalisée en silicium polycristallin ou en métal, est couplée capacitivement à la grille flottante par l'intermédiaire d'un oxyde 7. Les liaisons 22, 61, 81 et 91 représentent les connexions avec les autres éléments de circuit (non représentés) de la zone d'injection, de la grille de commande, de la source et du drain du transistor de lecture, respectivement. La cellule est réalisée de manière que la capacité entre l'électrode de commande et la grille flottante soit grande et que l'effet Fowler-Nordheim ne puisse se produire qu'à travers l'oxyde d'injection. A titre d'exemple, dans une stucture où l'oxyde d'injection est un isolant de 10 nm d'épaisseur d'une surface de 2x2 µm, le seuil d'injection (tension de Fowler-Nordheim) est de l'ordre de 10 volts pour un courant d'injection de 1 pA. Bien qu'un seul transistor de lecture T ait été représenté, il est bien évident que les cellules de mémoire à plusieurs transistors ayant pour grille la grille flottante sont également utilisables.

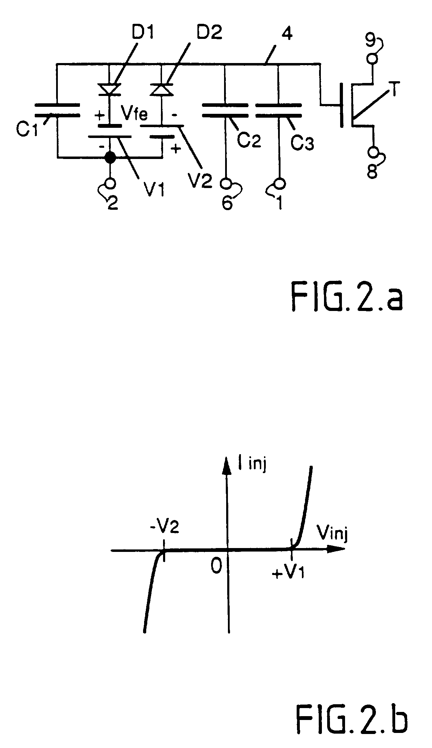

Un schéma équivalent de la cellule de la figure 1 est montré à la figure 2.a. La grille flottante 4 est couplée au substrat 1 par une capacité C3, à la grille de commande par une capacité C2 et à la zone d'injection 2 par un arrangement parallèle constitué par une capacité C1 et deux diodes en sens opposés. Les deux diodes sont symbolisées par la connexion en série d'une diode idéale D1 (respectivement D2) et d'une source de tension V1 (respectivement V2). La figure 2.b montre la variation du courant d'injection, à travers l'oxyde d'injection 3, en fonction de la tension appliquée à la zone d'injection 2. Ce courant est positif lorsque la tension appliquée est égale ou supérieure à la tension V2, il est négatif lorsqu'elle est égale ou inférieure à - V2 et il est nul lorsqu'elle est comprise entre - V2 et + V1.

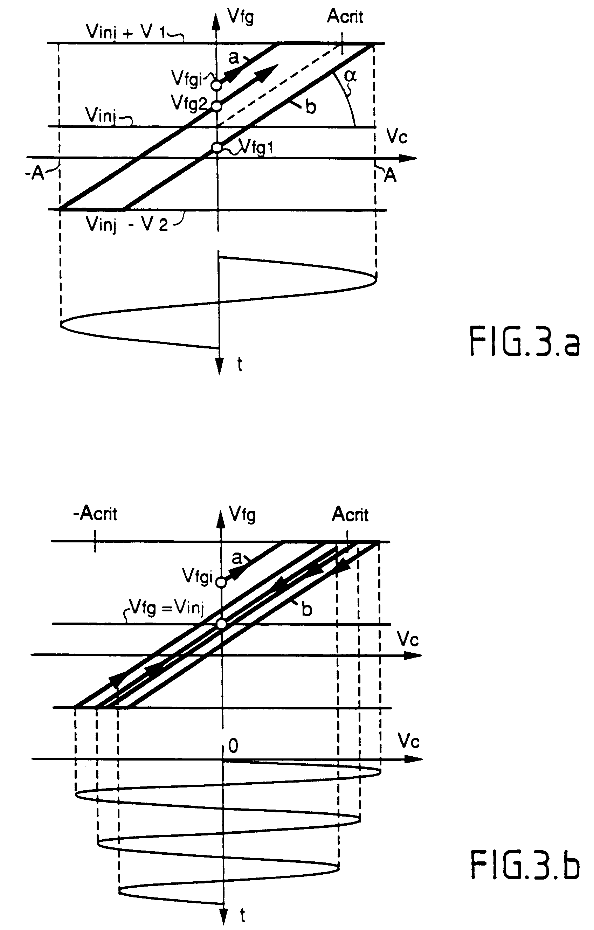

La figure 3.a montre l'évolution de la tension Vfg sur la grille flottante lorsque, une tension constante Vinj étant appliquée à la zone d'injection 2, la grille de commande est soumise à une tension alternative Vc d'amplitude A. Au départ lorsque Vc = 0, la tension sur la grille flottante a une valeur initiale quelconque Vfgi puis, lorsque Vc croît, la tension Vfg croît également en suivant une droite a de pente α = C2 / (C1+C2+C3) jusqu'à une valeur Vinj + V1 qu'elle conserve tant que Vc continue à croître. Lorsque Vc décroît, la tension Vfg décroît en suivant une autre droite b de même pente α qui coupe l'axe Vc = 0 au point Vfg1 = Vinj + V1 - α.A. Après l'alternance négative de Vc, la valeur de la tension sur la grille flottante lorsque Vc = 0 est: Vfg2 = Vinj - V2 + α.A. Si les tensions V1 et V2 sont telles que: V1 = V2 et l'amplitude A a une valeur critique Acrit = V1/α, on obtient alors: Vfg1 = Vfg2 = Vinj.

Il se peut que la tension Vinj utilisée pendant la phase de mémorisation ne soit plus disponible ou ait varié au moment de la lecture de l'information mémorisée. Dans ce cas si Vinja désigne la valeur de Vinj pendant la mémorisation et Vinjm sa valeur au moment de la lecture, la valeur lue Vfgm de la tension de la grille flottante sera: Vfgm = Vinja - β(Vinja - Vinjm), où β est égal à C1 / (C1 + C2 + C3) soit: β = α(C1 / C2). Le coefficient β sera, en pratique, petit par rapport à 1 de sorte que la tension Vfg soit peu modifiée entre la mémorisation et la lecture.

La figure 3.b montre comment la tension Vfg de la grille flottante converge vers la valeur Vinj de la tension appliquée à la zone d'injection si l'amplitude de la tension alternative, appliquée à la grille de commande, décroît régulièrement depuis une valeur supérieure à la valeur critique Acrit mentionnée ci-dessus.

On peut déduire de ce qui précède qu'après une excursion de la tension de commande entre les valeurs + Acrit et - Acrit, la tension résiduelle Vfg sur la grille flottante est indépendante des tensions de Fowler-Nordheim V1 et V2, du moins lorsque ces dernières sont égales, de la tension initiale Vfgi et du facteur de couplage α. Cette tension résiduelle ne dépend que de la tension Vinj appliquée à la zone d'injection. Dans le cas où les tensions V1 et V2 ne sont pas égales, c'est-à-dire si l'effet Fowler-Nordheim ne se produit pas de manière symétrique, la tension résiduelle sur la grille flottante sera alors décalée par rapport à la tension appliquée Vinj. Ce décalage est constant et égal à (V1 - V2) / 2. La valeur critique Acrit de la tension de commande est celle pour laquelle se produit une modification de la charge de la grille flottante. Si cette valeur critique n'est pas connue précisément, il suffit d'appliquer sur l'électrode de commande une tension alternative d'amplitude décroissante à partir d'une valeur supérieure à la valeur critique Acrit. La dernière valeur Vfg de la tension sur la grille flottante qui diffère des valeurs Vfg précédentes est celle qui correspond à la valeur critique Acrit de Vc. Il convient de noter que si une tension continue est superposée à la tension alternative appliquée sur l'électrode de commande et qu'elle est maintenue pendant la phase de lecture, la tension résiduelle sur la grille flottante n'en est pas affectée.

Le procédé selon l'invention consiste donc à appliquer sur l'électrode 22, reliée à la zone d'injection 2, une tension sensiblement égale à la tension à mémoriser et à appliquer simultanément à l'électrode de commande une tension alternative dont l'amplitude décroît depuis une valeur supérieure à la valeur critique Acrit pour laquelle la modification de la charge de la grille flottante peut intervenir. Selon une variante, la tension alternative à appliquer à l'électrode de commande ne comporte qu'une alternance positive et une alternance négative d'amplitude égale à ladite valeur critique. Selon un mode de réalisation préféré, la tension alternative est sinusoïdale.

Grâce au procédé de l'invention, il devient possible de mémoriser de manière simple et précise une grandeur analogique représentée sous la forme d'une tension. Un dispositif permettant de mettre en oeuvre le procédé de l'invention comprend donc une cellule de mémoire du type décrit précédemment, des moyens pour produire et appliquer sur l'électrode de commande une tension alternative dont une alternance positive et négative au moins a une amplitude égale à ladite valeur critique, indépendante de la tension à mémoriser, et des moyens pour appliquer à la zone d'injection la tension à mémoriser. Des exemples d'application vont maintenant être décrits.

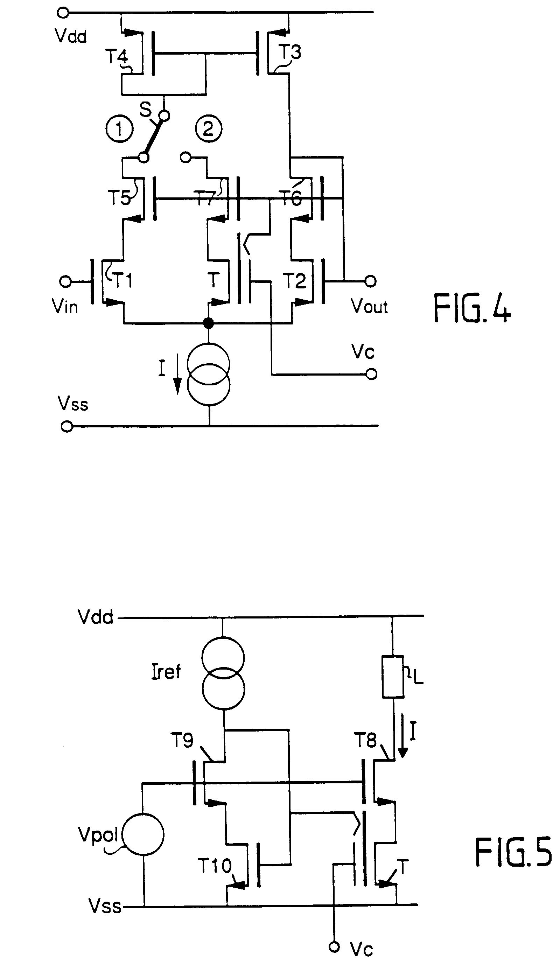

La figure 4 montre une source de tension ajustable utilisant une cellule de mémoire programmée selon le procédé de l'invention et réalisée à l'aide d'une technologie CMOS à caissons de type n. La source de tension ajustable comprend un amplificateur différentiel formé par les transistors T1 et T2, dont les grilles sont connectées à l'entrée Vin et à la sortie Vout respectivement, une source de courant I connectée entre l'alimentation Vss et les émetteurs de T1 et T2 et un miroir de courant, constitué par les transistors T3 et T4 reliés à la borne positive Vdd de l'alimentation. Le circuit comprend en outre les transistors T5 et T6, connectés en série avec les transistors T1 et T2 respectivement, ayant leur grille reliée à la borne de sortie Vout et formant avec T1 et T2 un montage "cascode". Une branche supplémentaire, constituée par le transistor de lecture T d'une cellule de mémoire conforme à la présente invention et un transistor T7 identique aux transistors T5 et T6, peut être connectée en lieu et place des transistors T1 et T5 grâce au commutateur S. Pendant une phase ① de mémorisation, la tension Vin appliquée sur la grille de T1 et reproduite, via le montage différentiel, sur la grille du transistor T2 et sur la zone d'injection de la cellule de mémoire, est mémorisée sur la grille flottante du transistor de lecture T en appliquant une tension alternative convenable Vc sur l'électrode de commande de la cellule de mémoire. Pendant la phase ②de lecture, les transistors T et T7 sont substitués aux transistors T1 et T5, de sorte que c'est la tension de la grille flottante qui détermine la tension de sortie. Cette tension est également appliquée à la zone d'injection, de façon à éliminer l'erreur produite par un couplage capacitif à la grille flottante.

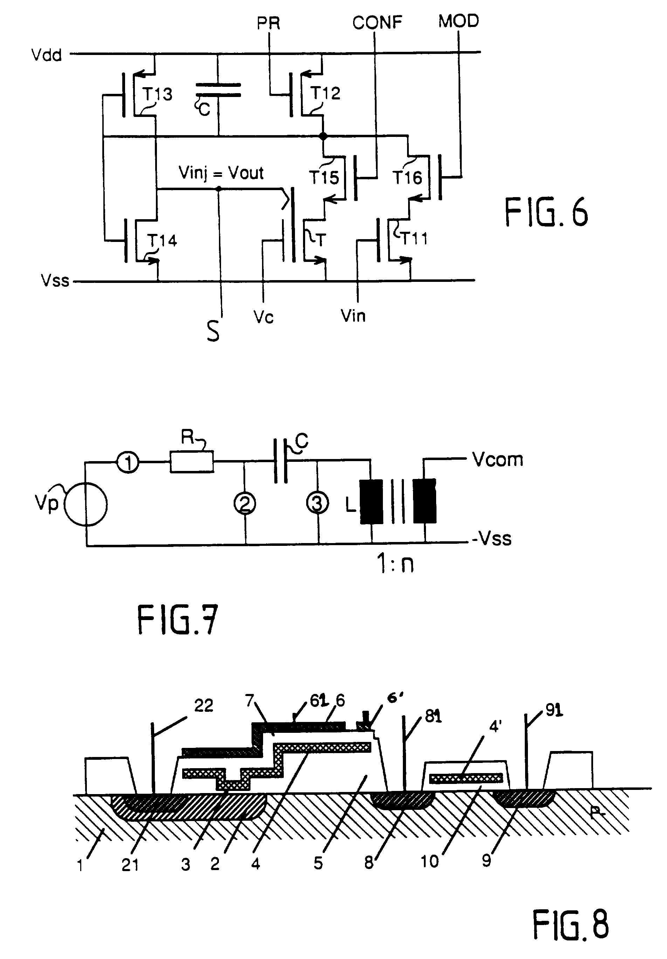

La figure 5 montre une source de courant ajustable. En phase de lecture, la source de courant comprend le transistor T d'une cellule de mémoire selon les principes de l'invention et un transistor de découplage T8. Le courant I alimente un circuit de charge L quelconque. Un circuit associé à la phase de mémorisation comprend une source de courant de référence Iréf, un transistor de découplage T9 et un transistor de transfert T10. La grille de T10 est connectée au drain de T9 et la tension Vpol est choisie de telle sorte que T10 travaille à faible tension de drain. La grille de T10 est également reliée à la zone d'injection de la cellule de mémoire. De préférence les transistors T8 et T9 d'une part, et les transistors T10 et T d'autre part, seront appairés. Pendant la phase de mémorisation, une tension alternative adéquate Vc est appliquée sur l'électrode de commande de la cellule de mémoire, ce qui a pour effet d'assurer le transfert de la tension de la grille de T10 sur la grille flottante. Après disparition de la tension de commande Vc, la tension de la grille flottante sera maintenue. De nombreuses variantes de ce circuit sont possibles. Par exemple, plusieurs branches identiques à l'arrangement T/T8 peuvent être connectées en parallèle pour alimenter avec le même courant I plusieurs circuits de charge différents. Le transistor de lecture T peut être court-circuité pendant la phase de mémorisation pour maintenir à zéro la source et le drain et améliorer la précision de la valeur stockée.

La figure 6 montre un circuit de mémoire dans lequel la cellule de mémoire est utilisée pour mémoriser une information binaire. Pour le fonctionnement du circuit, on distingue une phase de précharge, pendant laquelle les entrées CONF, MOD, Vc et PR sont à zéro, une phase de lecture, pendant laquelle les entrées MOD, Vc et PR sont toujours à zéro mais l'entrée CONF passe à 1 et une phase d'inscription, pendant laquelle la tension Vc est une tension alternative de valeur adéquate, les entrées PR et CONF sont à zéro, l'entrée MOD est à 1 et une tension Vin est appliquée sur la grille du transistor T11. Pendant la précharge le transistor T12 conduit, les transistors T13, T15 et T16 sont bloqués, le circuit ne consomme pas de courant. Pendant la lecture, la sortie S prend une valeur qui dépend de l'état de conduction du transistor T, transmis par le transistor T15, la capacité C et l'inverseur T13-T14, et donc, de la charge qui a été stockée sur la grille flottante. Pendant la phase d'inscription, la tension Vin appliquée sur la grille du transistor T11 est transférée, via le transistor T16 et l'inverseur T13-T14, à la zone d'injection de la cellule de mémoire et elle est stockée sur la grille flottante. De nombreuses variantes de ce schéma sont possibles, ainsi qu'une organisation matricielle des cellules de mémoire. Il convient de noter que la haute tension Vc est appliquée, pendant la phase d'inscription, de manière non sélective aux électrodes de commande et ce, indépendamment de la valeur de la tension à mémoriser. De plus il n'y a pas lieu de distinguer, à l'inverse des mémoires de l'art antérieur, l'opération d'inscription de celle d'effacement. La tension à mémoriser Vin (0 ou 1 logique) est appliquée dans tous les cas à la zone d'injection, sans distinction de la valeur précédemment mémorisée.

La figure 7 montre un exemple de générateur de la tension de commande Vc utilisant un circuit résonnant de type L-C. Dans une phase préparatoire, la capacité C est chargée à travers une résistance R et un interrupteur ①à la tension Vp d'une source de tension et l'inductance L est court-circuitée par l'interrupteur ③ pour ne pas perturber la sortie Vc. Dans la phase de transfert, la capacité C est brusquement connectée à la masse par l'interrupteur ② tandis que les interrupteurs ① et ③ sont ouverts. Une sinusoïde amortie est engendrée dans l'inductance L, dont l'amplitude initiale est égale à Vp au primaire et à n.Vp au secondaire. A titre d'exemple, si Vp = 5V et n = 4, l'amplitude de la première alternance de Vc est de 20 volts. La fréquence propre du circuit L-C est de 10 à 100 kHz. En-dessous de ces valeurs, la durée de l'inscription devient trop grande et au-dessus de celles-ci, l'endurance des cellules de mémoire risque d'en être affectée.

Le circuit précédent peut être notablement amélioré si la tension Vp est asservie aux tensions de Fowler-Nordheim (V1 et V2). Dans ce cas, la tension Vc sera juste suffisante pour assurer la mémorisation. Un autre perfectionnement consiste à raccourcir encore la phase de mémorisation en amortissant très rapidement le circuit L-C dès que l'amplitude de la tension Vc est inférieure auxdites tensions de Fowler-Nordheim. Il suffit pour cela de revenir à la phase préparatoire; ce qui peut être réalisé de manière simple pour l'homme de l'art à l'aide d'un détecteur d'amplitude, d'un circuit temporisateur ou encore, en fixant convenablement les signaux d'horloge qui commandent les interrupteurs ①, ② et ③.

Il a été mentionné précédemment que l'effet Fowler-Nordheim pouvait ne pas s'exercer de manière symétrique et qu'il s'ensuivait un décalage entre la tension appliquée à la zone d'injection et la tension mémorisée sur la grille flottante. Un moyen de correction utilisable consiste à appliquer sur la grille de commande, pendant la phase de lecture, une tension de correction qui peut être déterminée en mesurant le décalage précité sur une cellule de mémoire de référence pour laquelle la tension appliquée à la zone d'injection pendant la phase de mémorisation est disponible en permanence pendant la phase de lecture. Une autre solution qui permet de découpler les circuits de correction de ceux de commande consiste à utiliser une électrode de commande supplémentaire 6' dont la surface est beaucoup plus petite que celle de l'électrode de commande 6 pour ne pas dégrader le facteur de couplage α. Une cellule comportant une telle électrode de correction est illustrée à la figure 8 dans laquelle les éléments analogues à ceux de la figure 1.a portent les mêmes références.

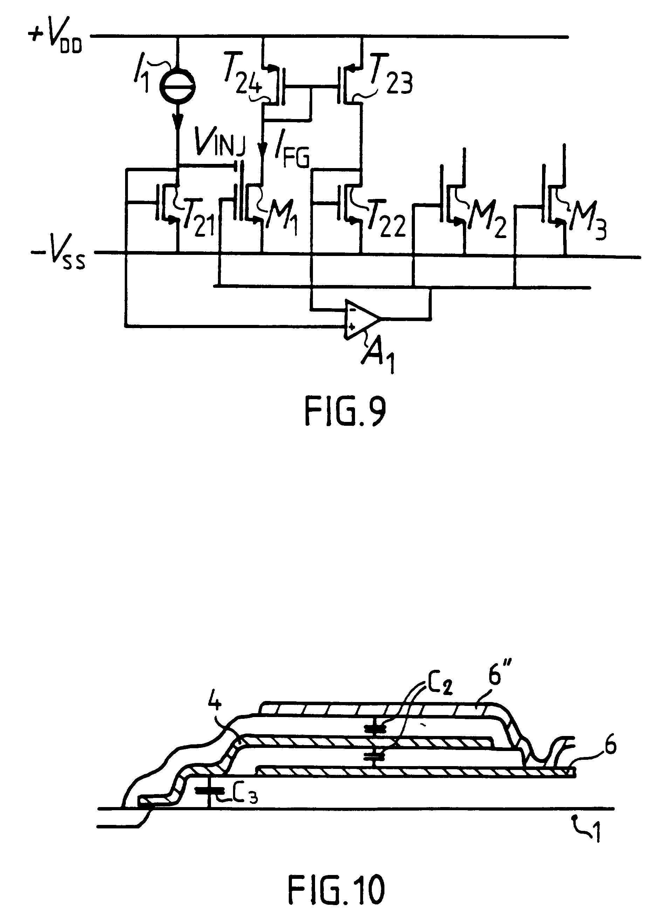

La figure 9 montre un exemple de circuit permettant de corriger la valeur mémorisée. Les transistors T21, T22 et le transistor de lecture de la cellule de mémoire M1 sont des transistors MOS à canal n appairés. Les transistors T23 et T24 sont des transistors MOS à canal p appairés également et formant un miroir de courant. Le transistor T21 est alimenté par une source de courant I1 de telle sorte que la tension Vinj sur son drain soit voisine de sa tension de seuil. Pendant la mémorisation (dont les moyens ne sont pas représentés dans cette figure), la tension sur la grille flottante de M1 s'ajuste à une valeur Vfg = Vinj + Voff, où Voff représente la tension de décalage mentionnée plus haut entre la tension appliquée à la zone d'injection et la tension mémorisée sur la grille flottante; tension de décalage qui peut exister si, par exemple, l'effet Fowler-Nordheim n'est pas symétrique. Le courant engendré dans le transistor M1 par la tension de sa grille flottante est réinjecté dans le transistor T22 par le miroir de courant T23-T24. La comparaison du courant I1 et du courant engendré par M1 est réalisée en comparant, à l'aide d'un amplificateur différentiel A1, les tensions de grille des transistors T21 et T22. La sortie de l'amplificateur A1 est alors appliquée sur les électrodes de correction des cellules de mémoire M1, M2, M3,..., qui sont supposées identiques et présentant la même tension de décalage.

La figure 10 montre, en coupe, une réalisation particulière de cellule de mémoire dans une technologie CMOS à deux niveaux de silicium polycristallin. Dans cette réalisation, la grille flottante 4 est réalisée avec le deuxième niveau de polysilicium et elle est prise en "sandwich" entre une couche en silicium polycristallin de niveau 1 et une couche de métal formant l'électrode de commande 6. Cet arrangement permet, pour un coefficient de couplage donné entre la grille de commande et la grille flottante, de réaliser une cellule d'encombrement moindre que celle de la figure 1 et, de plus, il offre une capacité réduite C3 entre la grille flottante et le substrat.

Bien que la présente invention ait été décrite dans le cas d'exemples de réalisation particuliers, il est clair que ces derniers sont susceptibles de modifications ou de variantes sans pour autant sortir de son domaine. En particulier, des cellules de mémoire utilisant les principes de la présente invention pourront avantageusement trouver application dans la réalisation de réseaux analogiques de neurones en permettant la mémorisation et l'ajustement des grandeurs analogiques que sont les poids synaptiques.

## Revendications

1. Procédé pour la mémorisation d'une grandeur analogique dans une cellule de mémoire non-volatile comportant au moins une structure de transistor MOS à grille flottante isolée réalisée sur un substrat semiconducteur, une électrode de commande couplée capacitivement à ladite grille flottante et une zone d'injection, séparée de ladite grille flottante par un isolant mince, capable d'injecter dans ou d'extraire de ladite grille flottante des charges électriques en réponse à l'application d'une différence de tension convenable entre ladite électrode de commande et ladite zone d'injection; ledit procédé étant caractérisé en ce qu'on applique à ladite électrode de commande une tension comprenant au moins une alternance positive et une alternance négative dont les amplitudes sont égales à la valeur pour laquelle se produit une modification de la charge de ladite grille flottante et en ce qu'on applique à ladite zone d'injection une tension représentant ladite grandeur analogique à mémoriser.

2. Procédé selon la revendication 1, caractérisé en ce que ladite tension appliquée à l'électrode de commande est une tension alternative dont l'amplitude décroît depuis une valeur supérieure à celle pour laquelle se produit une modification de la charge de ladite grille flottante jusqu'à une valeur inférieure à celle-ci.

3. Procédé selon la revendication 1 ou la revendication 2, caractérisé en ce que lesdites alternances positives et négatives de la tension appliquée à l'électrode de commande sont centrées par rapport au potentiel dudit substrat.

4. Procédé selon la revendication 1 ou la revendication 2, caractérisé en ce que lesdites alternances positives et négatives de la tension appliquée à l'électrode de commande sont centrées par rapport à un potentiel différent de celui dudit substrat et en ce qu'on applique ce même potentiel à l'électrode de commande à chaque lecture de ladite grandeur analogique mémorisée.

5. Procédé selon l'une quelconque des revendications 2 à 4, caractérisé en ce que ladite tension alternative est une tension sinusoïdale amortie.

6. Dispositif pour la mise en oeuvre du procédé selon la revendication 1, comportant une cellule de mémoire non-volatile ayant au moins une structure de transistor MOS à grille flottante isolée réalisée sur un substrat semiconducteur, une électrode de commande couplée capacitivement à ladite grille flottante et une zone d'injection séparée de la grille flottante par un isolant mince et capable d'injecter dans ou d'extraire de ladite grille flottante des charges électriques en réponse à l'application d'une différence de tension convenable entre ladite électrode de commande et ladite zone d'injection; ledit dispositif étant caractérisé en ce qu'il comprend en outre un générateur de tension alternative, dont la sortie est connectée, au moins pendant la phase de mémorisation, à ladite électrode de commande et dont l'amplitude d'au moins une alternance positive et une alternance négative de ladite tension alternative est égale à ladite valeur pour laquelle se produit une modification de la charge de ladite grille flottante, et des moyens pour appliquer à ladite zone d'injection, au moins pendant ladite phase de mémorisation, une tension représentant la grandeur à mémoriser.

7. Dispositif selon la revendication 6, caractérisé en ce que ledit générateur de tension alternative délivre une tension sinusoïdale amortie.

8. Dispositif selon la revendication 6 ou la revendication 7, caractérisé en ce qu'il comporte en outre une électrode de correction couplée capacitivement à ladite grille flottante et sur laquelle est appliquée une tension de correction pour compenser le décalage entre ladite tension à mémoriser et la tension réellement mémorisée sur la grille flottante.

9. Dispositif selon la revendication 6, caractérisé en ce que ladite électrode de commande comprend deux parties électriquement connectées et disposées de part et d'autre de ladite grille flottante.

## Patentansprüche

1. Verfahren zum Abspeichern einer analogen Größe in einer nicht-flüchtigen Speicherzelle, umfassend mindestens eine MOS-Transistorstruktur mit isoliertem schwingendem Gate, realisiert auf einem Halbleitersubstrat, eine Steuerelektrode, die kapazitiv an das schwimmende Gate gekoppelt ist, und eine Injektionszone, die von dem schwimmenden Gate durch eine dünne Isolierung getrennt ist und in der Lage ist, in das schwimmende Gate elektrische Ladungen zu injizieren oder aus ihm zu extrahieren in Reaktion auf das Anlegen einer entsprechenden Spannungsdifferenz zwischen der Steuerelektrode und der Injektionszone, welches Verfahren dadurch gekennzeichnet ist, daß man an die Steuerelektrode eine Spannung anlegt, umfassend mindestens einen ins Positive und einen ins Negative gehenden Wechsel, dessen Amplituden gleich dem Wert sind, für den sich eine Modifikation der Ladung des schwimmenden Gates ergibt und daß man an die Injektionszone eine Spannung anlegt, welche die abzuspeichernde analoge Größe repräsentiert.

2. Verfahren nach Anspruch 1, dadurch gekennzeichnet, daß die an die Steuerelektrode angelegte Spannung eine Wechselspannung ist, deren Amplitude abnimmt, ausgehend von einem Wert, der größer ist als jener, für den sich eine Modifikation der Ladung des schwimmenden Gates ergibt, bis zu einem Wert unterhalb derselben.

3. Verfahren nach Anspruch 1 oder Anspruch 2, dadurch gekennzeichnet, daß die positiven und negativen Wechsel der an die Steuerelektrode angelegten Spannung bezüglich des Potentials des Substrats zentriert sind.

4. Verfahren nach Anspruch 1 oder Anspruch 2, dadurch gekennzeichnet, daß die positiven und negativen Wechsel der an die Steuerelektrode angelegten Spannung bezüglich eines Potentials zentriert sind, das abweicht von dem des Substrats, und daß man dasselbe Potential an die Steuerelektrode bei jedem Lesen der abgespeicherten analogen Größe anlegt.

5. Verfahren nach einem der Ansprüche 2 bis 4, dadurch gekennzeichnet, daß die Wechselspannung eine gedämpfte Sinusspannung ist.

6. Vorrichtung für die Ausführung des Verfahrens nach Anspruch 1, umfassend eine nicht-flüchtige Speicherzelle mit mindestens einer MOS-Transistorstruktur mit isoliertem schwimmendem Gate, realisiert auf einem Halbleitersubstrat, mit einer kapazitiv mit dem schwimmenden Gate gekoppelten Steuerelektrode und mit einer Injektionszone, die von dem schwimmenden Gate durch eine dünne Isolierung getrennt ist und in der Lage ist, in das schwimmende Gate elektrische Ladungen zu injizieren oder aus ihm zu extrahieren in Reaktion auf das Anlegen einer geeigneten Spannungsdifferenz zwischen der Steuerelektrode und der Injektionszone, welche Vorrichtung dadurch gekennzeichnet ist, daß sie ferner einen Wechselspannungsgenerator umfaßt, dessen Ausgang zumindest während der Abspeicherungsphase mit der Steuerelektrode verbunden ist und dessen Amplitude von mindestens einem ins Positive und einem ins Negative gehenden Wechsel der Wechselspannung gleich ist dem Wert, für welchen sich eine Modifikation der Ladung des schwimmenden Gates ergibt, und ferner Mittel für das Anlegen an die Injektionszone mindestens während der Abspeicherungsphase einer die abzuspeichernde Größe repräsentierenden Spannung umfaßt.

7. Vorrichtung nach Anspruch 6, dadurch gekennzeichnet, daß der Wechselspannungsgenerator eine gedämpfte Sinusspannung erzeugt.

8. Vorrichtung nach Anspruch 6 oder Anspruch 7, dadurch gekennzeichnet, daß sie ferner eine Korrekturelektrode umfaßt, kapazitiv an das schwimmende Gate angekoppelt, und an die eine Korrekturspannung angelegt ist zum Kompensieren der Verschiebung zwischen der abzuspeichernden Spannung und der Spannung, die tatsächlich auf dem schwimmenden Gate abgespeichert wird.

9. Vorrichtung nach Anspruch 6, dadurch gekennzeichnet, daß die Steuerelektrode zwei elektrisch verbundene und beidseits des schwimmenden Gates angeordnete Partien umfaßt.

## Claims

1. Method for storing an analogue value in a non-volatile memory cell having at least one insulated floating gate MOS transistor structure produced on a semiconductor substrate, a control electrode coupled capacitively to the said floating gate and an injection region, separated from the said floating gate by a thin insulant, able to inject into or extract from the said floating gate electrical charges in response to the application of an appropriate voltage difference between the said control electrode and the said injection region; the said method being characterised in that a voltage comprising at least one positive half cycle and one negative half cycle whose amplitudes are equal to the value at which a modification of the charge of the said floating gate occurs are applied to the said control electrode and in that a voltage representing the said analogue value to be stored is applied to the said injection region.

2. Method according to Claim 1, characterised in that the said voltage applied to the control electrode is an alternating voltage whose amplitude falls from a value above that at which a modification in the charge of the said floating gate occurs to a value below this.

3. Method according to Claim 1 or Claim 2, characterised in that the said positive and negative half cycles of the voltage applied to the control electrode are centred with respect to the potential of the said substrate.

4. Method according to Claim 1 or Claim 2, characterised in that the said positive and negative half cycles of the voltage applied to the control electrode are centred with respect to a potential different from that of the said substrate and in that this same potential is applied to the control electrode with each reading of the said stored analogue value.

5. Method according to any one of Claims 2 to 4, characterised in that the said alternating voltage is a damped sinusoidal voltage.

6. Device for the implementation of the method according to Claim 1, including a non-volatile memory cell having at least one insulated floating gate MOS transistor structure produced on a semiconductor substrate, a control electrode coupled capacitively to the said floating gate and an injection region, separated from the said floating gate by a thin insulant, able to inject into or extract from the said floating gate electrical charges in response to the application of an appropriate voltage difference between the said control electrode and the said injection region; the said device being characterised in that it also comprises an alternating voltage generator whose output is connected, at least during the storage phase, to the said control electrode, and whose amplitude of at least one positive half cycle and one negative half cycle of the said alternating voltage is equal to the said value at which a modification of the charge of the said floating gate occurs, and means for applying to the said injection region, at least during the said storage phase, a voltage representing the value to be stored.

7. Device according to Claim 6, characterised in that the said alternating voltage generator delivers a damped sinusoidal voltage.

8. Device according to Claim 6 or Claim 7, characterised in that it also has a correction electrode coupled capacitively to the said floating gate and to which there is applied a correction voltage for compensating for the difference between the said voltage to be stored and the voltage actually stored on the floating gate.

9. Device according to Claim 6, characterised in that the said control electrode comprises two electrically connected parts disposed on each side of the said floating gate.
